# EUROPEAN PATENT SPECIFICATION

(11) **EP 0 344 282 B1**
(45) Date of publication and mention of the grant of the patent: **06.04.1994**
(21) Application number: 89900632.4
(22) Date of filing: 14.12.1988
(51) Int. Cl.: H01L 21/84, H01L 21/00, H01L 21/90

(54) **SEMI-CONDUCTIVE DEVICES FABRICATED ON SOI WAFERS**
AUF SOI-SCHEIBEN HERGESTELLTE HALBLEITERANORDNUNGEN
DISPOSITIFS SEMICONDUCTEURS FABRIQUES SUR DES TRANCHES SOI (SILICIUM SUR ISOLATEUR)

(30) Priority: 19.12.1987 GB 8729652
(43) Date of publication of application: 06.12.1989
(73) Proprietor: PLESSEY SEMICONDUCTORS LIMITED, Swindon, Wiltshire SN2 2QW (GB)
(72) Inventor: WILLIAMS, Brian, David, Cogenhoe Northampton (GB)
(74) Representative: Nicholson, Ronald
(86) International application number: GB8801113
(87) International publication number: WO8906046

(56) References cited:
- EP-A- 0 244 848
- FR-A- 2 235 485
- GB-A- 2 077 039
- US-A- 4 634 496

## Description

This invention relates to the manufacture of semiconductive devices on SOI (Silicon On Insulator) wafers. The invention is particularly, but not exclusively, concerned with the manufacture of MOS (Metal Oxide Silicon) transistors on such wafers.

A disadvantage of the present manufacturing process lies in that, when critical device pattern details of dimension approximately one micron or less are optically imaged onto a wafer, the depth of focus of the projection lenses is very shallow. The lenses are operating close to the limits of their resolution. further if the imaged surface, whereover a photosensitive resist is applied, has non-specular reflective properties, light reflected therefrom is scattered. Thus, if the surface is uneven or of a non-specular reflective material, the photosensitive resist is exposed not only to the desired image but also to the out of focus and/or scattered reflective light. The sharpness of the image formed is reduced and, further, dimensional control of critical feature size is worsened.

A method of producing thin film transistors (TFT) comprising the planarisation of the surfaces prior to photolitographic stages is known from GB-A-2 077 039.

It is an object of the present invention, to provide an improved method of manufacturing semi-conductor devices on SOI wafers wherein the aforesaid disadvantages are minimised.

According to the present invention, there is provided a method of fabricating a silicon on insulator device on an insulating substrate comprising the steps of:
forming a layer of silicon on an insulating layer so as to define at least one isolated area of silicon on said layer;
forming a layer of insulating material over at least the isolated area of silicon;
etching a gate recess in the layer of insulating material to expose a region of the isolated area of silicon;
forming a gate oxide layer over said region of the isolated area of silicon;
depositing polysilicon to fill the recess and to cover the layer of insulating material;
isotropically etching the polysilicon from the layer of insulating material and from over the filled recess to leave a substantially planar surface; and
coating the substantially planar surface with a resist material on which an image is defined for subsequent formation of source and drain areas.

The invention also provides a semiconductor device manufactured by the method aforesaid.

The invention will be described further, by way of example, with reference to the accompanying drawings, in which:-

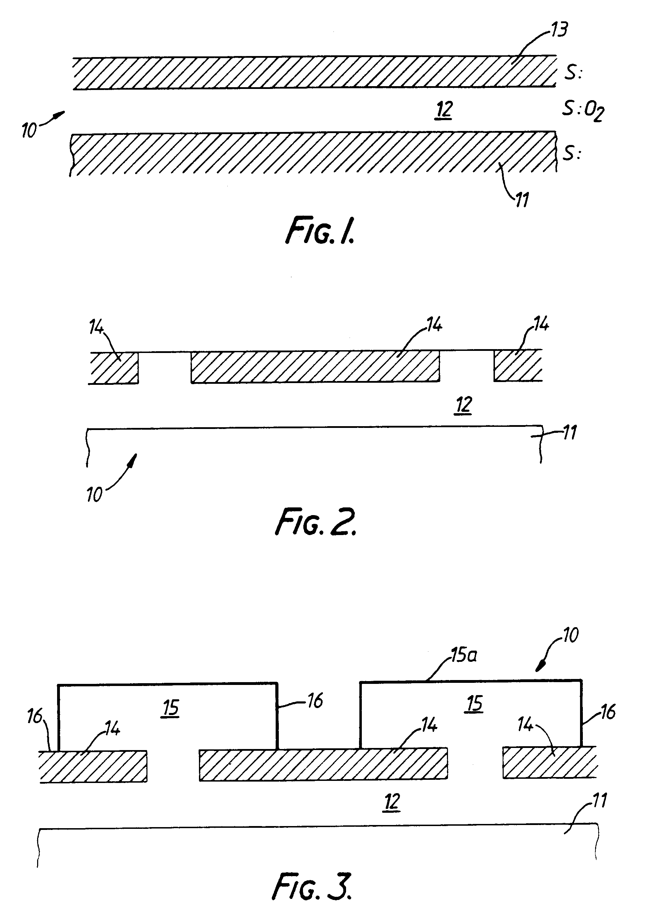

Figures 1 to 8 are diagrammatic cross-sections illustrating the various stages of carrying out a method of manufacturing a semiconductive device, incorporating the present invention.

Referring to the drawings, there is shown in Figure 1 a fragmentary cross-section of an SOI (Silicon on Insulator) wafer 10. The wafer 10 comprises a substrate 11 of silicon, a layer 12 of SᵢO₂ insulant, and a layer 13 of silicon. The layers 12 and 13 may be formed in any known SOI process.

The surface of the layer 13 is formed as smoothly as possible. In any known way, the Si layer 13 is "printed" and then etched to form isolated areas 14 of silicon each of which will provide a semiconductive device.

The wafer 10 has SᵢO₂ deposited thereon to form a layer filling the interstices between, and covering the isolated areas 14. Thhis layer (not shown) is then isotropically etched to provide a substantially coplaner surface as shown in Figure 2. Such fabrication steps are conventional. At this stage the coplanar surface is coated with a resist and exposed to define the devices.

N channel (and/or P channel) locations as required are printed and implanted on each of the isolated areas 14. Thereafter, SᵢO₂ in accordance with the invention, is again deposited on the surface to form a layer 15 having a smooth surface 15a on which the gates are printed. The SᵢO₂ layer 15 is then anisotropically etched to define gate recesses 16 down to the isolated areas 14.

A gate oxide layer 17 is grown at the bottom of each recess 16. The gate oxide areas so grown are accurately defined by the preformed recessor. Thus, the conventional step of growing a gate oxide layer on a surface and, thereafter, resist coating, exposing and etching to define the gate oxide regions is avoided. Thereafter, a polysilicon layer 18 is deposited on the wafer 10 and isotropically etched to leave a substantially coplanar upper surface 19 with the gate recesses 16 filled with the remnants of the polysilicon layer 18.

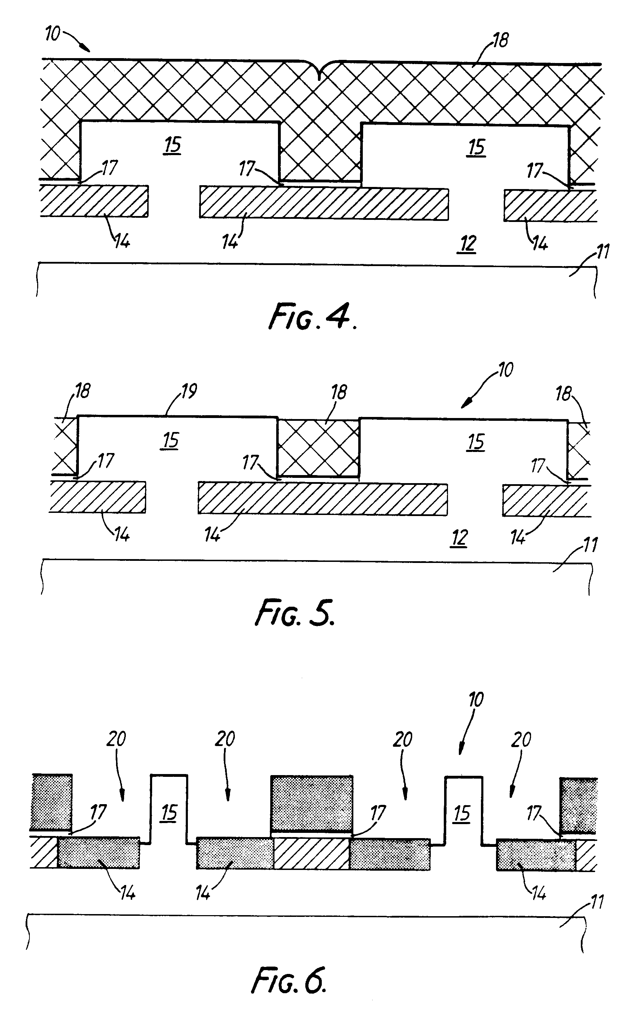

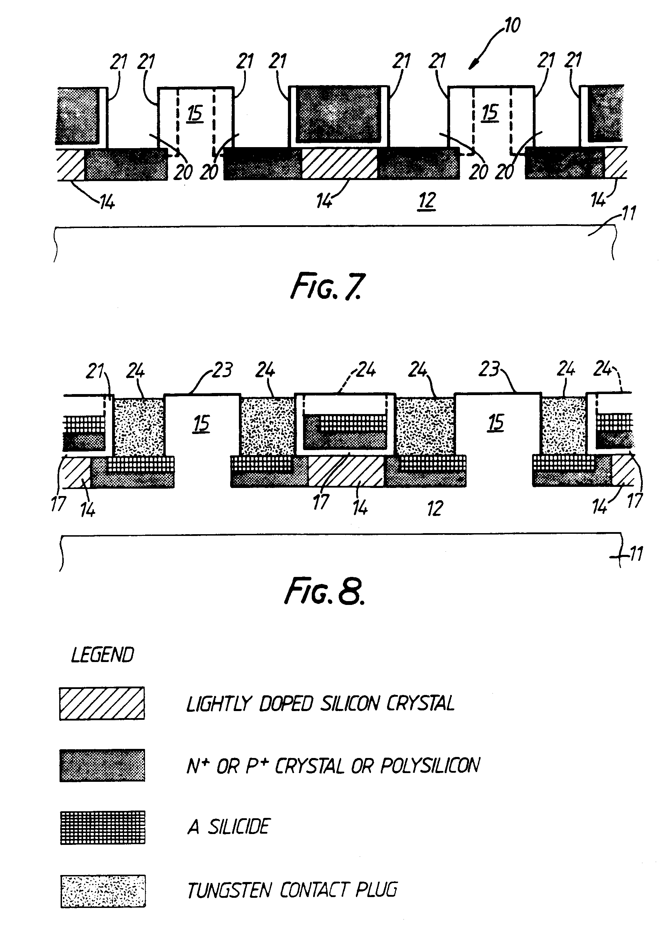

On the coplanar surface 19, source and drain areas are printed and the SᵢO₂ is an anisotropically etched down to the areas 14 forming recesses 20 as shown in Figure 6. On the exposed coplanar Silicon areas 14, N+ regions are printed and implanted (and/or, if required, P+ regions printed and implanted). After such implantation, SᵢO₂ is again deposited and anisotropically etched to leave SᵢO₂ sidewalls 21 in the recesses 20. The drain and source regions are extended with a silicide deposition 22. SᵢO₂ is again deposited to provide a coplanar surface 23 on which contact areas are printed. The contact areas are anisotropically etched to form contact walls. Tungsten is deposited and isotropically etched to provide tungsten contact plugs 24 in the contact wells (the plug for the gate contact is offset from the plane of the drawing of Figure 8 and is indicated by the dotted lines).

An example is given hereafter of the steps involved in carrying out the invention.

A starting material is a wafer of Silicon-on-Insulator as shown in Fig. 1. The following steps are effected:-
1. Print Isolation;
2. Etch Isolation;
3. Deposit SᵢO₂;
4. Isotrapically etch SᵢO₂.

The resulting planar structure is as shown in Fig. 2. The following steps are then effected:-
1. Print N Channel, Implant;
2. Alternatively or additionally, Print P Channel; Implant;
3. Deposit SᵢO₂;
4. Print Gates;
5. Etch Gate Recesses;
As shown in Fig. 3, the Gate Areas are now defined and the following steps may be effected:-
1. Grow Gate Oxide;
2. Deposit Polysilicon;
3. Isotropically etch polysilicon.

In this way, the Gate electrodes are defined as shown in Figs. 4 and 5. Therefore the following steps may be effected:-
1. Print Sources and Drains;
2. Anisatropically etch to form Sources and Drains;
3. Print N⁺ Source and Drain;
4. Implant N⁺;
5. Alternatively or additionally Print and Implant P⁺ Sources and Drains;
As shown in Fig. 6, the sources, drains, gate oxides and gates are now formed. The remaining steps comprise isolation and contact formation as follows:-
1. Deposite SᵢO₂;
2. Anisatropically blanket etch (Fig. 7);
3. Silicide to form extended contacts;
4. Deposit SᵢO₂;
5. Print Contacts;
6. Anisatropically etch contact wells;
7. Deposit tungsten;
8. Isotrapically etch tungsten.

The active device, as shown in Fig. 8, are thus completed.

All of the stages of printing are effected upon a substantially coplanar surface which, in a preceding stage, has been accurately produced at a predetermined level. In this way, the physical limitations of the projection lenses are minimised in that the printing surface is located in an known optimum plane of focus thereof. Further, by appropriate choice of deposited material, printing may be effected on a specularly or substantially transparent surface thereby avoiding degradation of the printed image by back scatter of light caused by non specular reflection of the surface immediately below the photo resist or other photosensitive material used in the exposure and printing process.

The invention is not confined to the precise details of the foregoing example and variations may be made thereto. For instance, the invention is applicable to other fabrication processes than the formation of semi-conductive devices on SOI wafers. Other insulants than Silicon di-oxide such as silicon nitride may be used as the deposited material.

## Claims

1. A method of fabricating a silicon on insulator device on a substrate comprising the steps of:
forming a layer (13) of silicon on an insulating layer (12) so as to define at least one isolated area (14) of silicon on said layer (12);
forming a layer (15) of insulating material over at least the isolated area (14) of silicon;
etching a gate recess (16) in the layer (15) of insulating material to expose a region of the isolated area (14) of silicon;
forming a gate oxide layer (17) over said region of the isolated area (14) of silicon;
depositing polysilicon (18) to fill the recess (16) and to cover the layer (15) of insulating material;
isotropically etching the polysilicon (18) from the layer (15) of insulating material and from over the filled recess (16) to leave a substantially planar surface (19); and
coating the substantially planar surface (19) with a resist material on which an image is defined for subsequent formation of source and drain areas.

2. A method of fabricating a silicon on insulator device in accordance with Claim 1 wherein the insulating layer (12) is of silicon dioxide.

3. A method of fabricating a silicon on insulator device in accordance with Claim 1 wherein the layer (15) of insulating material is of silicon dioxide.

## Patentansprüche

1. Verfahren zur Herstellung einer Silizium-auf-Isolator-Vorrichtung auf einem Substrat, welches folgende Schritte umfaßt:
das Bilden einer Siliziumschicht (13) auf einer isolierenden Schicht (12), um so zumindest eine isolierte Fläche (14) von Silizium auf der Schicht (12) zu definieren;
das Bilden einer Schicht (15) von isolierendem Material über zumindest die isolierte Fläche (14) von Silizium;
das Ätzen einer Tor-Ausnehmung (16) in der Schicht (15) von isolierendem Material, um einen Bereich der isolierten Fläche (14) von Silizium freizulegen;
das Bilden einer Tor-Oxydschicht (17) über den Bereich der isolierten Fläche (14) von Silizium;
das Ablagern von Polysilizium (18), um die Ausnehmung (16) zu füllen und die Schicht (15) von isolierendem Material zu bedecken;
das isotropische Ätzen des Polysiliziums (18) von der Schicht (15) von isolierendem Material und von über der gefüllten Ausnehmung (16), um eine im wesentlichen ebene Oberfläche (19) übrigzulassen; und
das Überziehen der im wesentlichen ebenen Oberfläche (19) mit einem Abdeckmaterial, auf dem ein Bild für die nachfolgende Bildung von Quelle- und Senke-Flächen definiert ist.

2. Verfahren zur Herstellung einer Silizium-auf-Isolator-Vorrichtung nach Anspruch 1, bei dem die isolierende Schicht (12) aus Siliziumdioxid besteht.

3. Verfahren zur Herstellung einer Silizium-auf-Isolator-Vorrichtung nach Anspruch 1, bei dem die Schicht (15) von isolierendem Material aus Siliziumdioxid besteht.

## Revendications

1. Procédé de fabrication d'un dispositif silicium sur isolant sur un substrat, comprenant les étapes de :
formation d'une couche (13) en silicium sur une couche isolante (12) de manière à définir au moins une zone isolée (14) en silicium sur ladite couche (12) ;
formation d'une couche (15) en matériau isolant sur au moins la zone isolée (14) en silicium ;
gravure d'un évidement de grille (16) dans la couche (15) en matériau isolant afin de mettre à nu une région de la zone isolée (14) en silicium ;
formation d'une couche d'oxyde de grille (17) sur ladite région de la zone isolée (14) en silicium ;
dépôt de polysilicium (18) afin de remplir l'évidement (16) et de recouvrir la couche (15) en matériau isolant ;
gravure isotrope du polysilicium (18) par rapport à la couche (15) en matériau isolant et à l'évidement rempli (16) afin de laisser une surface sensiblement plane (19) ; et
revêtement de la surface sensiblement plane (19) avec un matériau de réserve sur lequel une image est définie en vue de la formation ultérieure de zones de source et de drain.

2. Procédé de fabrication d'un dispositif silicium sur isolant selon la revendication 1, dans lequel la couche isolante (12) est en dioxyde de silicium.

3. Procédé de fabrication d'un dispositif silicium sur isolant selon la revendication 1, dans lequel la couche (15) en matériau isolant est en dioxyde de silicium.
